# EUROPEAN PATENT APPLICATION

(11) **EP 4 838 713 A1**
(43) Date of publication of application: **11.11.2026**
(21) Application number: 24914997.2
(22) Date of filing: 08.11.2024
(51) Int. Cl.: H01R 13/02, H01R 13/73, H05K 5/02, H05K 5/06, H02K 7/10, H02K 5/10

(54) **CONNECTING DEVICE, DRIVING ASSEMBLY, AND VEHICLE**

(30) Priority: 02.01.2024 CN 202410008998
(71) Applicant: BYD Company Limited, Shenzhen, Guangdong 518118 (CN)
(72) Inventor: YANG, Shenglin, Shenzhen, Guangdong 518118 (CN); LI, Wenxiang, Shenzhen, Guangdong 518118 (CN); ZHANG, Hepeng, Shenzhen, Guangdong 518118 (CN); TANG, Lizhong, Shenzhen, Guangdong 518118 (CN); GAO, Yuan, Shenzhen, Guangdong 518118 (CN)
(74) Representative: Mathys & Squire
(86) International application number: PCT/CN2024/131083
(87) International publication number: WO 2025/145781

(57) **Abstract**

A vehicle includes a drive assembly. The drive assembly includes a connection apparatus. The connection apparatus includes a first connection base and a second connection base. The first connection base extends in a first direction, a plurality of first input ends are respectively disposed on both sides of the first connection base in a second direction, and the first direction and the second direction intersect. The second connection base is electrically connected to the first connection base, the second connection base extends in the second direction, and a plurality of second output ends are disposed on the second connection base.

## Description

### CROSS REFERENCE TO RELATED APPLICATIONS

The present disclosure claims priority to Chinese Patent Application No. 202410008998.3, filed with the China National Intellectual Property Administration on January 2, 2024 and entitled "CONNECTION APPARATUS, DRIVE ASSEMBLY, AND VEHICLE", which is incorporated herein by reference in its entirety.

### TECHNICAL FIELD

The present disclosure relates to the field of electric drive technologies, and in particular, to a connection apparatus, a drive assembly, and a vehicle.

### BACKGROUND

In conventional technologies, for a dual-motor drive assembly, two motors are electrically connected to an electronic control apparatus through a connection apparatus. However, the connection apparatus features complex structure, complex production process, and high assembly difficulty, leading to high assembly process costs and material costs. This hinders cost reduction and assembly efficiency improvement.

### SUMMARY

The present disclosure aims to resolve at least one of the technical problems in conventional technologies. To this end, a first objective of the present disclosure is to propose a connection apparatus with a compact structure and low assembly process difficulty.

A second objective of the present disclosure is to provide a drive assembly, including the connection apparatus.

A third objective of the present disclosure is to provide a vehicle, including the connection apparatus or the drive assembly.

A connection apparatus according to embodiments of a first aspect of the present disclosure includes: a first connection base and a second connection base. The first connection base extends in a first direction, a plurality of first input ends are respectively disposed on both sides of the first connection base in a second direction, and the first direction and the second direction intersect. The second connection base is electrically connected to the first connection base, the second connection base extends in the second direction, and a plurality of second output ends are disposed on the second connection base.

According to the connection apparatus in this embodiment of the present disclosure, the first connection base and the second connection base that are interconnected extend in the first direction and the second direction respectively, so that the plurality of first input ends can be disposed on the first connection base for connection with different motors, avoiding the need for a plurality of intermediate transfer steps. This can reduce material variety and assembly errors between the first connection base and the second connection base and components such as motors, reducing costs and improving reliability of the connection apparatus. This allows for a more compact structure of the connection apparatus, reducing size of the connection apparatus. In addition, this effectively reduces difficulty of an assembly process, and is beneficial to an integrated and miniaturized configuration of the connection apparatus.

In some embodiments, the first connection base includes a first connection portion and a second connection portion. The first connection portion extends in the first direction, and the plurality of first input ends are disposed on both sides of the first connection portion in the second direction. The second connection portion is connected to the first connection portion, the second connection portion extends in the second direction, the second connection base is electrically connected to the second connection portion, and the first direction is perpendicular to the second direction.

In some embodiments, the plurality of first input ends include a plurality of first input sub-ends and a plurality of second input sub-ends. The plurality of first input sub-ends are spaced apart in the first direction on one side of the first connection portion in the second direction. The plurality of second input sub-ends are spaced apart in the first direction on the other side of the first connection portion in the second direction.

In some embodiments, the plurality of first input sub-ends and the plurality of second input sub-ends form a symmetrical structure with respect to the first connection portion.

In some embodiments, a plurality of first output ends are disposed on the second connection portion; and a plurality of second input ends are disposed on the second connection base, and the plurality of second input ends are electrically connected to the plurality of first output ends to implement electrical connection between the second connection base and the first connection base.

In some embodiments, the plurality of first output ends are located on a side of the plurality of first input ends adjacent to the second connection base.

In some embodiments, the plurality of first output ends are spaced apart in the second direction, and the plurality of first output ends respectively correspond to the plurality of first input ends. The plurality of second input ends are spaced apart in the second direction, and the plurality of second input ends are respectively connected to the plurality of first output ends.

In some embodiments, first connection holes are respectively formed in the plurality of first output ends; and second connection holes are respectively formed in the plurality of second input ends, and the plurality of first connection holes and the plurality of second connection holes are respectively opposite to each other and connected by fasteners to implement mechanical connection and electrical connection between the second connection base and the first connection base.

In some embodiments, the plurality of second output ends are located on a side of the plurality of second input ends that is away from the first connection base.

In some embodiments, a plurality of mounting positions are provided on at least one of the first connection portion and the second connection portion.

In some embodiments, the plurality of mounting positions include a plurality of first mounting positions and a plurality of second mounting positions. The plurality of first mounting positions are provided on the first connection portion; and the plurality of second mounting positions are provided on the second connection portion, and the plurality of second mounting positions are respectively located on both sides of the plurality of first output ends.

In some embodiments, the plurality of first mounting positions include a plurality of first mounting sub-positions and a plurality of second mounting sub-positions. The plurality of first mounting sub-positions are provided at an end of the first connection portion that is away from the second connection portion, and the plurality of first mounting sub-positions are arranged in the second direction. In the first direction, the plurality of second mounting sub-positions are located between the plurality of first mounting sub-positions and the plurality of second mounting positions.

In some embodiments, a plurality of guide slots are formed in the second connection portion, and the plurality of first output ends are respectively disposed within the plurality of guide slots. The plurality of second input ends are respectively in guiding engagement with the plurality of guide slots and respectively electrically connected to the plurality of first output ends.

In some embodiments, a plurality of positioning pins are disposed on at least one of the first connection base and the second connection base.

In some embodiments, the plurality of positioning pins includes a plurality of first positioning pins and a plurality of second positioning pins. The plurality of first positioning pins are disposed at both ends of the first connection base in the first direction, the plurality of first positioning pins are located on a side of the first connection base in a third direction, and the third direction, the first direction, and the second direction are orthogonal. The plurality of second positioning pins are disposed at both ends of the second connection base in the second direction, and the plurality of second positioning pins are located on a side of the second connection base that faces the first connection base.

In some embodiments, one of the plurality of first positioning pins is disposed at an end of the first connection portion that is away from the second connection portion, and another of the plurality of first positioning pins is disposed at an end of the second connection portion in the second direction.

In some embodiments, the plurality of first positioning pins are integrally molded with the first connection base, and the plurality of second positioning pins are integrally molded with the second connection base.

In some embodiments, the positioning pin is a tapered positioning pin.

In some embodiments, a middle portion of the second connection base is connected to an end of the first connection base in the first direction.

A drive assembly according to embodiments of a second aspect of the present disclosure includes a housing, an electronic control apparatus, a first motor, a second motor, and a connection apparatus. The electronic control apparatus is disposed within the housing. The first motor and the second motor are disposed within the housing. The connection apparatus is the connection apparatus according to any of the above embodiments, the first motor and the second motor are electrically connected to the plurality of first input ends of the first connection base of the connection apparatus, and the electronic control apparatus is electrically connected to the plurality of second output ends of the second connection base of the connection apparatus.

In some embodiments, the first motor and the second motor are located on both sides of the first connection base, and the first motor and the second motor are electrically connected to the first input end on a corresponding side.

In some embodiments, the housing has a motor cavity and an electronic control cavity, the first motor and the second motor are disposed within the motor cavity, the electronic control apparatus is disposed within the electronic control cavity, the first connection base is disposed within the motor cavity, and the second connection base is disposed within the electronic control cavity.

In some embodiments, the drive assembly further includes a sealing member. The sealing member is disposed between the second connection base and the housing to seal the motor cavity and the electronic control cavity.

A vehicle according to embodiments a third aspect of the present disclosure includes the connection apparatus in any of the above embodiments or the drive assembly in any of the above embodiments.

Additional aspects and advantages of the present disclosure are partially provided in the following descriptions, and will partially become apparent from the following descriptions, or may be learned from practice of the present disclosure.

### DESCRIPTION OF DRAWINGS

The above and/or additional aspects and advantages of the present disclosure will become apparent and easily understood from descriptions of embodiments with reference to the following drawings, in which:
FIG. 1 is a diagram of a connection apparatus according to an embodiment of the present disclosure;
FIG. 2 is a diagram from one perspective of a first connection base according to an embodiment of the present disclosure;
FIG. 3 is a diagram from another perspective of a first connection base according to an embodiment of the present disclosure;
FIG. 4 is a diagram from one perspective of a second connection base according to an embodiment of the present disclosure;
FIG. 5 is another diagram of a connection apparatus according to an embodiment of the present disclosure;
FIG. 6 is a diagram from another perspective of a second connection base according to an embodiment of the present disclosure;
FIG. 7 is a diagram of assembly of a connection apparatus, an electronic control apparatus, and a motor according to an embodiment of the present disclosure;
FIG. 8 is a diagram of an internal structure of a drive assembly according to an embodiment of the present disclosure;
FIG. 9 is a diagram of a sealing member according to an embodiment of the present disclosure;
FIG. 10 is a position diagram in which a connection apparatus is disposed between an electronic control apparatus and a motor according to an embodiment of the present disclosure;
FIG. 11 is a diagram of circuit connection between an electronic control apparatus and a motor according to an embodiment of the present disclosure;
FIG. 12 is a block diagram of a vehicle according to an embodiment of the present disclosure; and
FIG. 13 is another block diagram of a vehicle according to an embodiment of the present disclosure.

### Reference numerals:

1: drive assembly; 2: connection apparatus; 3: housing; 301: electronic control cavity; 302: motor cavity; 4: electronic control apparatus; 5: first motor; 501: first wiring terminal; 6: second motor; 601: second wiring terminal;
10: first connection base; 11: first connection portion; 111: first input end; 1111: first input sub-end; 1112: second input sub-end; 12: second connection portion; 121: first output end; 1211: first connection hole; 122: guide slot; 13: first mounting position; 131: first mounting sub-position; 132: second mounting sub-position; 14: second mounting position; 15: first positioning pin; 16: fastener; 17: sealing member;
20: second connection base; 21: second output end; 22: second input end; 221: second connection hole; 23: second positioning pin;
1000: vehicle; 133: mounting position; 134: positioning pin.

### DESCRIPTION OF EMBODIMENTS

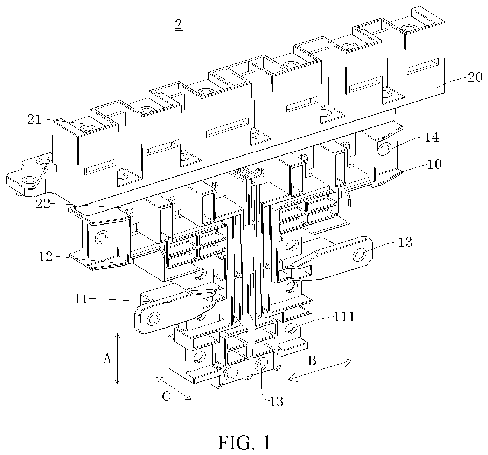

The following describes embodiments of the present disclosure in detail, and embodiments described with reference to the accompanying drawings are examples. The following describes a connection apparatus 2 according to an embodiment of the present disclosure with reference to FIG. 1 to FIG. 11. The connection apparatus 2 includes a first connection base 10 and a second connection base 20.

Specifically, as shown in FIG. 1 to FIG. 6, the first connection base 10 extends in a first direction A, a plurality of first input ends 111 are respectively disposed on both sides of the first connection base 10 in a second direction B, and the first direction A and the second direction B intersect. The second connection base 20 is electrically connected to the first connection base 10, the second connection base 20 extends in the second direction B, and a plurality of second output ends 21 are disposed on the second connection base 20.

In this embodiment, the first connection base 10 extends in the first direction A, the second connection base 20 is connected to an end of the first connection base 10 in the first direction A, the second connection base 20 extends in the second direction B, and the first connection base 10 and the second connection base 20 are connected in a T-shape. The plurality of first input ends 111 are respectively disposed on both sides of the first connection base 10 in the second direction B, and the plurality of first input ends 111 on each side in the second direction B are spaced apart in the first direction A. The plurality of second output ends 21 may be disposed on a side of the second connection base 20 that is away from the first connection base 10 for electrical connection with the electronic control apparatus 4. When the first connection base 10 is connected to the two motors, the first connection base 10 may be disposed between the two motors for electrical connection to the two motors. To be specific, when the connection apparatus 2 is disposed between the two motors, the two motors are respectively electrically connected to the first input ends 111 on both sides of the first connection base 10 in the first direction A.

That the first direction A and the second direction B intersect will be understood as that the first direction A is perpendicular to the second direction B, but it is not limited to the case of being perpendicular. For example, the first direction A and the second direction B form an angle of 80 degrees or 70 degrees.

According to the connection apparatus 2 in this embodiment of the present disclosure, the first connection base 10 and the second connection base 20 that are interconnected extend in the first direction A and the second direction B respectively, so that the plurality of first input ends 111 can be disposed on the first connection base 10 for connection with different motors, avoiding the need for a plurality of intermediate transfer steps. This can reduce material variety and assembly errors between the first connection base 10 and the second connection base 20 and components such as motors, reducing costs and improving reliability of the connection apparatus 2. This allows for a more compact structure of the connection apparatus 2, reducing size of the connection apparatus 2. In addition, this effectively reduces difficulty of an assembly process, and is beneficial to an integrated and miniaturized configuration of the connection apparatus 2.

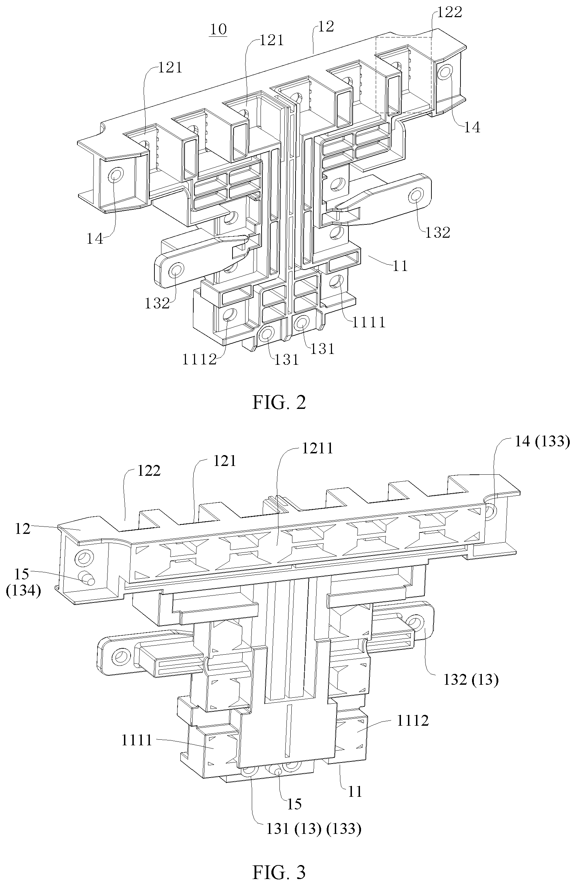

In some embodiments, as shown in FIG. 2, the first connection base 10 includes a first connection portion 11 and a second connection portion 12. The first connection portion 11 extends in the first direction A, and the plurality of first input ends 111 are disposed on both sides of the first connection portion 11 in the second direction B. The second connection portion 12 is connected to the first connection portion 11, the second connection portion 12 extends in the second direction B, the second connection base 20 is electrically connected to the second connection portion 12, and the first direction A is perpendicular to the second direction B. It will be understood that the first connection portion 11 and the second connection portion 12 are connected in a T-shape. The first connection portion 11 and the second connection portion 12 respectively extend in the first direction A and the second direction B. The plurality of first input ends 111 are disposed on both sides of the first connection portion 11 in the second direction B and are spaced apart on the first connection portion 11 in the first direction A. The two motors are electrically connected to the first connection portion 11 through the first input end 111, and the second connection portion 12 is electrically connected to the second connection base 20 through the second output end 21. Both the first input end 111 and the second output end 21 are wiring copper busbars.

In this way, arrangement of the first connection portion 11 and the second connection portion 12 facilitates arrangement of the first input end 111, and facilitates connection between the first connection base 10 and the second connection base 20. It makes full use of space on the connection apparatus 2, to avoid interference between the plurality of first input ends 111 and the plurality of second output ends 21. The second connection portion 12 that extends in the second direction B is opposite to the second connection base 20, facilitating connection with the second connection base 20.

In some embodiments, as shown in FIG. 3, the plurality of first input ends 111 include a plurality of first input sub-ends 1111 and a plurality of second input sub-ends 1112. The plurality of first input sub-ends 1111 are spaced apart in the first direction A on one side of the first connection portion 11 in the second direction B. The plurality of second input sub-ends 1112 are spaced apart in the first direction A on the other side of the first connection portion 11 in the second direction B. In this embodiment, for example, there are three first input sub-ends 1111 and three second input sub-ends 1112. The plurality of first input sub-ends 1111 are spaced apart in the first direction A, and the plurality of second input sub-ends 1112 are spaced apart in the first direction A. The plurality of first input sub-ends 1111 are adapted to be electrically connected to a motor located on the side, and the plurality of second input sub-ends 1112 are adapted to be electrically connected to a motor located on the other side.

In this way, arrangement of the first input sub-end 1111 and the second input sub-end 1112 facilitates electrical connection of both sides of the two motors with the first input sub-end 1111 and the second input sub-end 1112 respectively in the second direction B, increasing space utilization on both sides of the first connection portion 11.

In some embodiments, as shown in FIG. 2 and FIG. 3, the plurality of first input sub-ends 1111 and the plurality of second input sub-ends 1112 form a symmetrical structure with respect to the first connection portion 11. In other words, the plurality of first input sub-ends 1111 and the plurality of second input sub-ends 1112 that are disposed on both sides of the first connection portion 11 in the second direction B have the same structure, ensuring that dimensions of both sides of the first connection portion 11 that are electrically connected to the two motors in the second direction B are the same. This can ensure a consistent structure of lead wires of the two motors, reduce costs and assembly difficulty, and improve efficiency of connecting the first input sub-ends 1111 and the second input sub-ends 1112 to the motors.

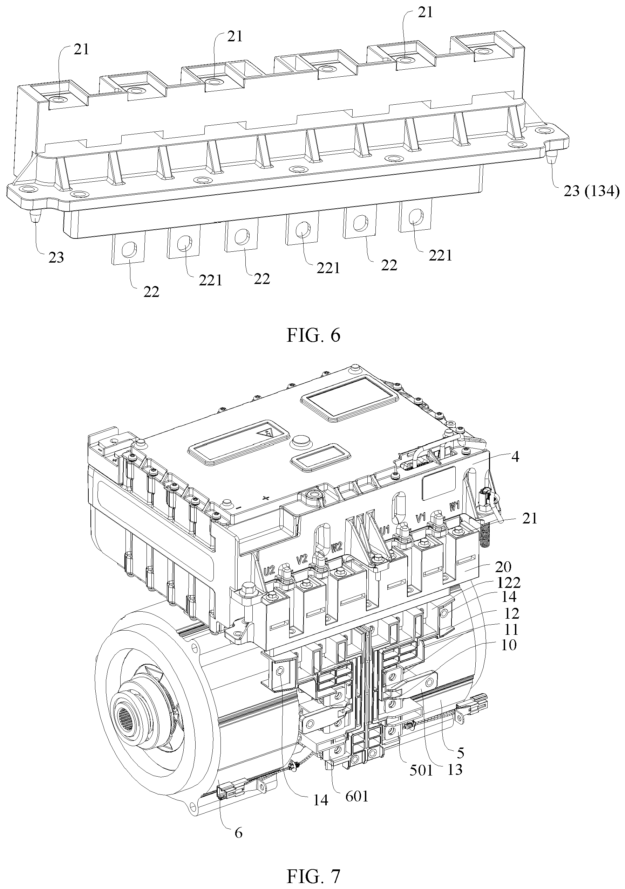

In some embodiments, as shown in FIG. 2 and FIG. 6, a plurality of first output ends 121 are disposed on the second connection portion 12; and a plurality of second input ends 22 are disposed on the second connection base 20, and the plurality of second input ends 22 are electrically connected to the plurality of first output ends 121 to implement electrical connection between the second connection base 20 and the first connection base 10. The plurality of first output ends 121 are spaced apart in the second direction B, and the plurality of first output ends 121 are opposite to and respectively electrically connected to the plurality of second input ends 22, to facilitate connection between the first connection base 10 and the second connection base 20 through the first output ends 121 and the second input ends 22. For example, the plurality of first output ends 121 include a plurality of first output sub-ends and a plurality of second output sub-ends, where the plurality of first output sub-ends are respectively connected to the plurality of first input sub-ends 1111, and are all located on the side of the second direction B. The plurality of second output sub-ends are respectively connected to the plurality of second input sub-ends 1112, and are located on the other side of the second direction B. The plurality of first output ends 121 correspond to the plurality of first input ends 111, so that the connection apparatus 2 that connects the two motors is placed between the two motors. This facilitates connection of the two motors to the first connection base 10 on both sides of the second direction B, increasing space utilization of the connection apparatus 2, and making better use of a gap between the two motors.

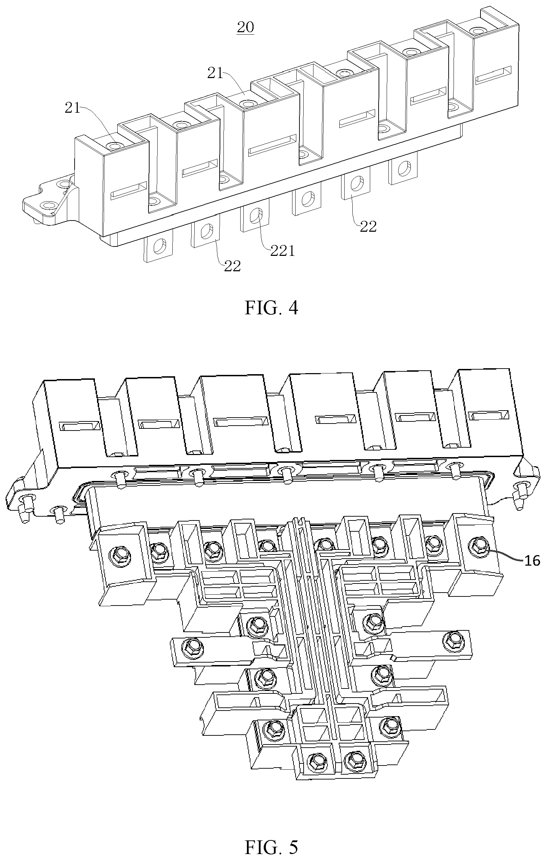

In some embodiments, as shown in FIG. 2 and FIG. 4, the plurality of first output ends 121 are located on a side of the plurality of first input ends 111 that is adjacent to the second connection base 20. In other words, the first output end 121 is disposed at an end of the first connection base 10 that is adjacent to the second connection base 20, and the second input end 22 is disposed at an end of the second connection base 20 that is adjacent to the first connection base 10. The plurality of first output ends 121 and the plurality of second input ends 22 are opposite to each other in the first direction A. In this way, the plurality of first output ends 121 are disposed on the side adjacent to the second connection base 20. This facilitates connection of the first output ends 121 to the second input ends 22, reduces a size of the connection apparatus 2 in the second direction B, and reduces space occupation on both sides of the first connection base 10 in the second direction B.

In some embodiments, as shown in FIG. 2, the plurality of first output ends 121 are spaced apart in the second direction B, and the plurality of first output ends 121 respectively correspond to the plurality of first input ends 111. For example, the first input ends 111 and the first output ends 121 are of the same quantity, and are connected in a one-to-one correspondence. The plurality of second input ends 22 are spaced apart in the second direction B, and the plurality of second input ends 22 are respectively connected to the plurality of first output ends 121. This facilitates connection of the first connection base 10 and the second connection base 20 at an end of the first connection base 10 in the first direction A. This avoids intermediate connection between the first connection base 10 and the second connection base 20, reducing costs and avoiding excessive space occupation.

In some embodiments, as shown in FIG. 3, FIG. 4 and FIG. 5, first connection holes 1211 are respectively formed in the plurality of first output ends 121; and second connection holes 221 are respectively formed in the plurality of second input ends 22, and the plurality of first connection holes 1211 and the plurality of second connection holes 221 are respectively opposite to each other and connected by fasteners 16 to implement mechanical connection and electrical connection between the second connection base 20 and the first connection base 10. Specifically, a first connection hole 1211 extending through the first output end 121 in a third direction C is formed on the first output end 121, and a second connection hole 221 extending through the second input end 22 in the third direction C is formed on the second input end 22, with the first connection hole 1211 and the second connection hole 221 facing each other in the third direction C. A fastener 16 passes through the first connection hole 1211 and the second connection hole 221 to fasten the first output end 121 to the second input end 22. The first output end 121 and the second input end 22 are conductive copper busbars, so that the first output end 121 and the second input end 22 can be mechanically connected and electrically connected, ensuring that components connected to the first connection base 10 and the second connection base 20 can be electrically energized.

In this way, arrangement of the first connection hole 1211 and the second connection hole 221 facilitates fastening and electrical connection between the first connection base 10 and the second connection base 20. In addition, arrangement of the connection holes reduces manufacturing difficulty of connecting the first connection base 10 to the second connection base 20, and improves efficiency of connecting the first connection base 10 to the second connection base 20.

In some embodiments, as shown in FIG. 2, the plurality of second output ends 21 are located on a side of the plurality of second input ends 22 that is away from the first connection base 10. To be specific, after the first connection base 10 is fastened to the second connection base 20, the second output end 21 disposed on the second connection base 20 is located on the side of the second connection base 20 that is away from the first connection base 10, and the first input end 111 disposed on the first connection base 10 is located on both sides of the first connection base 10 in the second direction B. In this way, position arrangement of the second output end 21 facilitates electrical connection between and installation of the second output end 21 and external devices such as electronic control devices, while reducing interference with the components installed on the first input end 111, allowing for a more optimised layout of the connection apparatus 2. This facilitates arrangement of components connected to the first connection base 10 and the second connection base 20, allows for a more compact structure of the connection apparatus 2, and is conducive to a miniaturized and integrated configuration of the connection apparatus 2.

In some embodiments, as shown in FIG. 2 to FIG. 6, a plurality of mounting positions 133 are provided on at least one of the first connection portion 11 and the second connection portion 12. For example, a part of the plurality of mounting positions 133 is provided on the first connection portion 11, and the other part of the plurality of mounting positions 133 is provided on the second connection portion 12. When the connection apparatus 2 needs to be fastened, for example, when the connection apparatus 2 is installed within a housing 3 of a drive assembly 1 with two motors, the connection apparatus 2 may be fastened to the housing 3 through the mounting position 133 disposed on the first connection portion 11 and the second connection portion 12. In this way, arrangement of the mounting position 133 facilitates installation of the first connection portion 11 and the second connection portion 12.

Further, reference is made to FIG. 1 and FIG. 2. The plurality of mounting positions 133 includes a plurality of first mounting positions 13 and a plurality of second mounting positions 14. The plurality of first mounting positions 13 are provided on the first connection portion 11, and the plurality of second mounting positions 14 are provided on the second connection portion 12. The plurality of second mounting positions 14 are respectively located on both sides of the plurality of first output ends 121. In this way, arrangement of the second mounting position 14 facilitates installation of the second connection portion 12. The second mounting position 14 is located at both ends of the second connection portion 12 in the second direction B, that is, on both sides of the plurality of first output ends 121 in the second direction B. Therefore, this can facilitate installation of the second connection portion 12 to balance a force on the second connection portion 12, increasing installation stability of the second connection portion 12. In addition, this can reduce manufacturing difficulty, avoid interference of the mounting position 133 with an arrangement position of the first output end 121, and increase arrangement safety of the mounting position 133.

In some embodiments, as shown in FIG. 2, the plurality of first mounting positions 13 include a plurality of first mounting sub-positions 131 and a plurality of second mounting sub-positions 132. The plurality of first mounting sub-positions 131 are provided at an end of the first connection portion 11 that is away from the second connection portion 12, and the plurality of first mounting sub-positions 131 are arranged in the second direction B. In the first direction A, the plurality of second mounting sub-positions 132 are located between the plurality of first mounting sub-positions 131 and the plurality of second mounting positions 14.

In this embodiment, there are two first mounting sub-positions 131 and two second mounting sub-positions 132. The two first mounting sub-positions 131 are provided at the end of the first connection portion 11 that is away from the second connection portion 12, and are spaced apart and adjacent to each other in the second direction B. The two second mounting sub-positions 132 are respectively provided on both sides of the first connection portion 11 in the second direction B. To be specific, one of the second mounting sub-positions 132 is provided between the plurality of first input sub-ends 1111, or between the first input sub-end 1111 and the first mounting sub-position 131, or between the first input sub-end 1111 and the second mounting position 14. The other second mounting sub-position 132 is provided between the plurality of second input sub-ends 1112, or between the second input sub-end 1112 and the first mounting sub-position 131, or between the second input sub-end 1112 and the second mounting position 14.

In some embodiments, as shown in FIG. 2, a plurality of guide slots 122 are formed in the second connection portion 12, and the plurality of first output ends 121 are respectively disposed within the plurality of guide slots 122. The plurality of second input ends 22 are respectively in guiding engagement with the plurality of guide slots 122 and respectively electrically connected to the plurality of first output ends 121. The guide slot 122 is open at an end facing the second connection base 20 in the first direction A. The second input end 22 disposed on the second connection base 20 may be in guiding engagement with the guide slot 122. To be specific, the second input end 22 may be inserted into the guide slot 122 in the first direction A for engagement with the guide slot 122. After engagement, the second input end 22 is electrically connected to the first output end 121 by using the fastener 16. In this way, the guide slot 122 may limit the second input end 22 in the second direction B, to prevent the second connection base 20 from shifting in the second direction B when the first connection base 10 is connected to the second connection base 20, thereby ensuring installation accuracy and improving installation efficiency.

In some embodiments, as shown in FIG. 3 and FIG. 6, a plurality of positioning pins 134 are disposed on at least one of the first connection base 10 and the second connection base 20. Arrangement of the plurality of positioning pins 134 facilitates pre-mounting positioning of the first connection base 10 and the second connection base 20, improving installation efficiency and accuracy.

In some embodiments, as shown in FIG. 3 and FIG. 6, the plurality of positioning pins 134 include a plurality of first positioning pins 15 and a plurality of second positioning pins 23. The plurality of first positioning pins 15 are disposed at both ends of the first connection base 10 in the first direction A, the plurality of first positioning pins 15 are located on a side of the first connection base 10 in a third direction C, and the third direction C, the first direction A, and the second direction B are orthogonal. In other words, a side of the first positioning pin 15 that faces the connection apparatus 2 in the third direction C may be specifically arranged based on a position of the connection apparatus 2 within the drive assembly 1 and which side of the housing 3 of the drive assembly 1 the connection apparatus 2 is connected to. This is not specifically limited herein. The first positioning pin 15 may provide support for the first connection base 10 in the first direction A.

With reference to FIG. 6, the plurality of second positioning pins 23 are disposed at both ends of the second connection base 20 in the second direction B, and the plurality of second positioning pins 23 are located on a side of the second connection base 20 that faces the first connection base 10. To be specific, the second positioning pin 23 is disposed on the second connection base 20 in the second direction B, and extends toward the first connection base 10 in the first direction A. When the second connection base 20 is installed, the second positioning pin 23 may support and limit the connection apparatus 2 in the first direction A. In this way, arrangement of the plurality of first positioning pins 15 and the plurality of second positioning pins 23 facilitates installation and positioning of the first connection base 10 and the second connection base 20, thereby simplifying installation of the first connection base 10 and the second connection base 20 and improving installation accuracy of the first connection base 10 and the second connection base 20.

In some embodiments, with reference to FIG. 3, one of the plurality of first positioning pins 15 is disposed at an end of the first connection portion 11 that is away from the second connection portion 12, and another of the plurality of first positioning pins 15 is disposed at an end of the second connection portion 12 in the second direction B. In this embodiment, there are two first positioning pins 15. One is disposed at the end of the first connection portion 11 that is away from the second connection portion 12, and the other is disposed on the side of the second connection portion 12 in the second direction B, to achieve positioning of the first connection base 10 in a plurality of directions. Optionally, the first positioning pins 15 are disposed on both sides of the second connection portion 12 in the second direction B.

In some embodiments, the plurality of first positioning pins 15 are integrally molded with the first connection base 10, and the plurality of second positioning pins 23 are integrally molded with the second connection base 20. The first positioning pin 15 and the second positioning pin 23 are respectively formed on the first connection base 10 and the second connection base 20 through an integral injection molding process. This may simplify a manufacturing of the first connection base 10 and the second connection base 20, enhance structural strength of the first positioning pin 15 and the second positioning pin 23, improve installation stability of the first connection base 10 and the second connection base 20, and accelerate a production cycle.

In some embodiments, the positioning pin 134 is a tapered positioning pin. This is mainly because the tapered positioning pin has a precise guiding function, ensuring that the connection apparatus 2 is accurately aligned with a mounting position of the connection apparatus 2 during installation. This can provide extremely stable positioning and support, thereby improving installation stability. This further facilitates assembly and disassembly of the connection apparatus 2, saving time and improving efficiency. In addition, this can adapt to different hole diameters, lowering requirements for matching holes.

In some embodiments, as shown in FIG. 1, a middle portion of the second connection base 20 is connected to an end of the first connection base 10 in the first direction A. In this embodiment, the second connection base 20 is opposite to the second connection portion 12 for fastening and electrical connection. The first connection portion 11 is disposed on a side of the second connection portion 12 that is away from the second connection base 20. An end of the first connection portion 11 that is adjacent to the second connection base 20 is connected to a middle portion of the second connection portion 12 in the second direction B. The first connection portion 11 and the second connection portion 12 are connected in a T-shape. The second connection base 20 is opposite to and connected to the second connection portion 12. Therefore, the first connection base 10 and the second connection base 20 are connected in a T-shape as a whole. In this way, an end of the first connection base 10 in the first direction A is connected to the middle portion of the second connection base 20. This facilitates utilization of space between the two motors by the connection apparatus 2, and helps realize a flat configuration of the connection apparatus 2, allowing the motors and electronic control to be connected to the connection apparatus 2 on the same side of the connection apparatus 2.

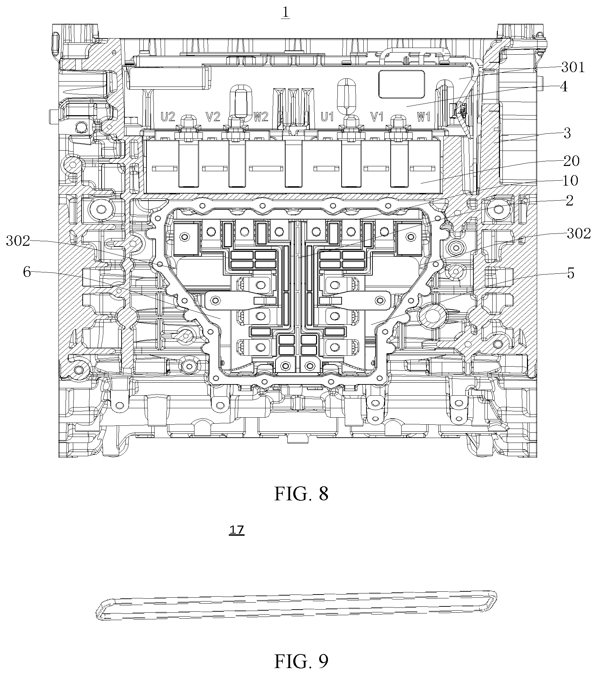

A drive assembly 1 according to embodiments of a second aspect of the present disclosure, as shown in FIG. 8, includes a housing 3, an electronic control apparatus 4, a first motor 5, a second motor 6, and a connection apparatus 2. The electronic control apparatus 4 is disposed within the housing 3. The first motor 5 and the second motor 6 are disposed within the housing 3. The connection apparatus 2 is the connection apparatus 2 according to any of the above embodiments, the first motor 5 and the second motor 6 are electrically connected to the plurality of first input ends 111 of the first connection base 10 of the connection apparatus 2, and the electronic control apparatus 4 is electrically connected to the plurality of second output ends 21 of the second connection base 20 of the connection apparatus 2.

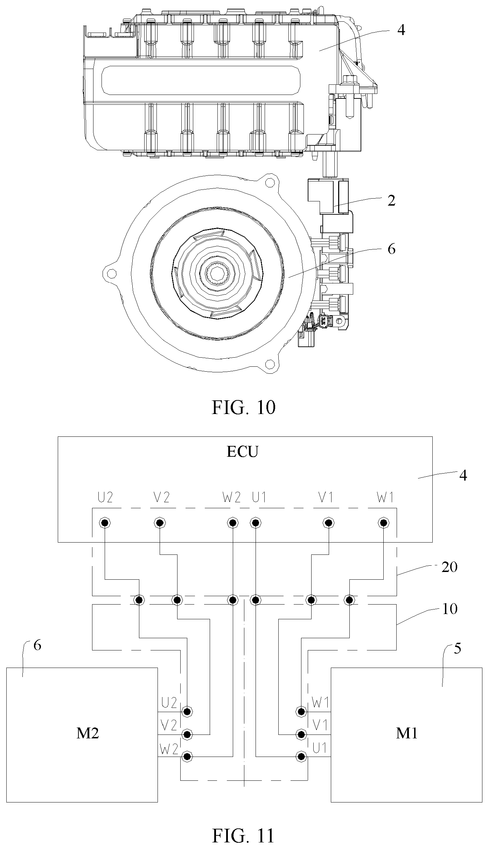

As shown in FIG. 7 and FIG. 10, the electronic control apparatus 4, a plurality of motors (such as the first motor 5 and the second motor 6) and the connection apparatus 2 are all disposed within the housing 3. The electronic control apparatus 4, the first motor 5, and the second motor 6 are all electrically connected to the connection apparatus 2. The electronic control apparatus 4, the first motor 5, and the second motor 6 are electrically connected through the connection apparatus 2. After the first motor 5, the second motor 6, and the electronic control apparatus 4 are connected to the connection apparatus 2, the first motor 5 and the second motor 6 are located on the same side of the first connection base 10 in the third direction C, and the electronic control apparatus 4 is disposed at an end of the second connection base 20 that is away from the first connection base 10, and extends in the third direction C toward the side on which the first motor 5 is located. The electronic control apparatus 4, the first motor 5, and the second motor 6 are located on the same side of the connection apparatus 2.

According to the drive assembly 1 in this embodiment of the present disclosure, the connection apparatus 2 as well as the motors and the electronic control apparatus 4 that are connected to the connection apparatus 2 are disposed within the housing 3, so that size of the drive assembly 1 can be reduced. This is beneficial to an integrated and miniaturized configuration of the drive assembly 1, and improves internal space utilization of the housing 3. In addition, the first motor 5, the second motor 6, and the electronic control apparatus 4 are all located on the same side of the connection apparatus 2 in the third direction C, facilitating utilization of space between the first motor 5 and the second motor 6, as well as space between the first motor 5, the second motor 6, and the electronic control apparatus 4. This can effectively reduce space occupied by the drive assembly 1 in the second direction B and reduce overall size of the drive assembly 1, improving overall layout feasibility of the vehicle.

In some embodiments, as shown in FIG. 7, the first motor 5 and the second motor 6 are located on both sides of the first connection base 10, and the first motor 5 and the second motor 6 are electrically connected to the first input end 111 on a corresponding side. The first motor 5 and the second motor 6 are disposed on both sides of the first connection base 10 in the second direction B, and are respectively electrically connected to the first input end 111 on the corresponding side. When the drive assembly 1 is disposed within the vehicle, space utilization within the vehicle in the third direction C can be increased. This facilitates a flat configuration of the connection bases and increases space utilization of the first connection base 10 in the second direction B.

With reference to FIG. 7 and FIG. 11, a first wiring terminal 501 is disposed on the first motor 5, and a second wiring terminal 601 is disposed on the second motor 6. There are a plurality of first wiring terminals 501 and a plurality of second wiring terminals 601. The plurality of first wiring terminals 501 are respectively electrically connected to the first input sub-ends 1111, and the plurality of second wiring terminals 601 are respectively electrically connected to the second input sub-ends 1112. When the second connection base 20 is connected to a motor apparatus, three second output ends 21 that are on the second connection base 20 and that are adjacent to the first motor 5 are respectively electrically connected to three-phase copper busbar terminals that are on the electronic control apparatus 4 and that control the first motor 5, and three second output ends 21 that are on the second connection base 20 and that are adjacent to the second motor 6 are respectively electrically connected to three-phase copper busbar terminals that are on the electronic control apparatus 4 and that control the second motor 6.

In some embodiments, as shown in FIG. 8, the housing 3 has a motor cavity 302 and an electronic control cavity 301, the first motor 5 and the second motor 6 are disposed within the motor cavity 302, the electronic control apparatus 4 is disposed within the electronic control cavity 301, the first connection base 10 is disposed within the motor cavity 302, and the second connection base 20 is disposed within the electronic control cavity 301. For example, the housing 3 has an intermediate plate. The motor cavity 302 and electronic control cavity 301 are formed on both sides of the intermediate plate. At least one intermediate hole is formed on the intermediate plate, and the motor cavity 302 and the electronic control cavity 301 are in communication through the intermediate hole. The second connection base 20 is disposed within the electronic control cavity 301 and abuts against the intermediate plate. The first connection base 10 is disposed within the motor cavity 302 and abuts against the intermediate plate. The electronic control apparatus 4 is disposed within the electronic control cavity 301 and is located on a side of the second connection base 20 that is away from the intermediate plate. The first motor 5 and the second motor 6 are disposed within the motor cavity 302 and are respectively disposed on both sides of the first connection base 10 and are separately connected to the first connection portion 11. The first motor 5, the second motor 6, the electronic control apparatus 4, and the connection apparatus 2 are separately connected to an inner wall of the housing 3.

In this way, the electronic control apparatus 4, the motor 5, and the motor 6 are respectively disposed within different cavities, so that oil, liquid, and other substances generated by the motors during operation may not affect the electronic control apparatus 4, enabling the electronic control apparatus 4 to efficiently adjust the first motor 5 and the second motor 6, improving stability and reliability of adjustment.

In some embodiments, as shown in FIG. 8 and FIG. 9, the drive assembly 1 further includes a sealing member 17. The sealing member 17 is disposed between the second connection base 20 and the housing 3 to seal the motor cavity 302 and the electronic control cavity 301. The sealing member 17 is disposed on a side of the second connection base 20 that faces the first connection base 10. When the second connection base 20 is installed within the electronic control cavity 301, the sealing member 17 is disposed between the second connection base 20 and the intermediate plate. The second connection base 20 may press the sealing member 17 to enhance sealing performance between the motor cavity 302 and the electronic control cavity 301, prevent paint in the motor cavity 302 from entering the electronic control cavity 301, and improve safety of the drive assembly 1. The sealing structure is simple and highly reliable, which can also reduce costs and manufacturing difficulty.

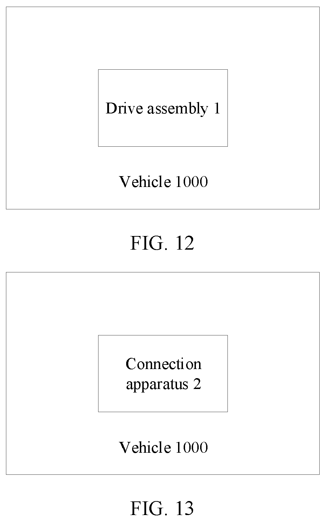

A vehicle 1000 according to embodiments of a third aspect of the present disclosure, as shown in FIG. 12 and FIG. 13, includes the connection apparatus 2 in any of the above embodiments or the drive assembly 1 in any of the above embodiments.

According to the vehicle 1000 in this embodiment of the present disclosure, the connection apparatus 2 is disposed between the first motor 5 and the second motor 6 of the drive assembly 1, and between the first motor 5, the second motor 6, and the electronic control apparatus 4. This may reduce a size of the drive assembly 1, and may be conducive to a miniaturized and integrated configuration of the drive assembly 1. This also facilitates connection between the first motor 5 and the second motor 6 and the connection apparatus 2, as well as layout of the electronic control apparatus 4 within the drive assembly 1. In addition, this facilitates control of the first motor 5 and the second motor 6 by the electronic control apparatus 4, providing more possibilities for overall layout of the vehicle 1000, and reducing costs of the vehicle 1000.

In the descriptions of the present disclosure, it will be understood that, directions or location relationships indicated by terms such as "center", "longitudinal", "lateral", "length", "width", "thickness", "above", "below", "front", "back", "left", "right", "vertical", "horizontal", "top", "bottom", "inside", "outside", "clockwise", "counterclockwise", "an axial direction", "a radical direction", "a circumferential direction", and the like are based on the directions or position relationships shown in the accompanying drawings, and are merely intended to describe the present disclosure and simplify the descriptions, but are not intended to indicate or imply that an indicated apparatus or element needs to have a specific direction or be constructed and operated in a specific direction, and therefore will not be understood as a limitation on the present disclosure.

In descriptions of the present disclosure, the "first feature" and the "second feature" may include one or more such features. In the descriptions of the present disclosure, "a plurality of" means two or more. In the descriptions of the present disclosure, a first feature being "above" or "below" a second feature may include direct contact between the first and second features, or may include that the first and second features may not be in direct contact, but in contact by means of another feature. In the descriptions of the present disclosure, the first feature being "on" or "above" or "over" the second feature includes the first feature being directly above and obliquely above the second feature, or simply means that the level of the first feature is higher than that of the second feature.

In the descriptions of this specification, the reference terms "an embodiment", "some embodiments", "an exemplary embodiment", "an example", "a specific example", or "some examples" and the like mean that the specific features, structures, materials, or characteristics described with reference to the embodiment or example are included in at least one embodiment or example of the present disclosure. In this specification, the exemplary expressions of the foregoing terms do not necessarily mean the same embodiments or examples.

Although embodiments of the present disclosure have been shown and described, a person of ordinary skill in the art will understand that various changes, modifications, substitutions, and variations may be made to these embodiments without departing from the principles and purposes of the present disclosure. The scope of the present disclosure is defined by the claims and their equivalents.

## Claims

1. A connection apparatus (2), comprising:
a first connection base (10), wherein the first connection base (10) extends in a first direction, a plurality of first input ends (111) are respectively disposed on both sides of the first connection base (10) in a second direction, and the first direction and the second direction intersect; and
a second connection base (20), wherein the second connection base (20) is electrically connected to the first connection base (10), the second connection base (20) extends in the second direction, and a plurality of second output ends (21) are disposed on the second connection base (20).

2. The connection apparatus (2) according to claim 1, wherein the first connection base (10) comprises:
a first connection portion (11), wherein the first connection portion (11) extends in the first direction, and the plurality of first input ends (111) are disposed on both sides of the first connection portion (11) in the second direction; and
a second connection portion (12), wherein the second connection portion (12) is connected to the first connection portion (11), the second connection portion (12) extends in the second direction, the second connection base (20) is electrically connected to the second connection portion (12), and the first direction is perpendicular to the second direction.

3. The connection apparatus (2) according to claim 2, wherein the plurality of first input ends (111) comprises:
a plurality of first input sub-ends (1111), wherein the plurality of first input sub-ends (1111) are spaced apart in the first direction on one side of the first connection portion (11) in the second direction; and
a plurality of second input sub-ends (1112), wherein the plurality of second input sub-ends (1112) are spaced apart in the first direction on the other side of the first connection portion (11) in the second direction.

4. The connection apparatus (2) according to claim 3, wherein the plurality of first input sub-ends (1111) and the plurality of second input sub-ends (1112) form a symmetrical structure with respect to the first connection portion (11).

5. The connection apparatus (2) according to any one of claims 2 to 4, wherein a plurality of first output ends (121) are disposed on the second connection portion (12); and
a plurality of second input ends (22) are disposed on the second connection base (20), and the plurality of second input ends (22) are electrically connected to the plurality of first output ends (121) to implement electrical connection between the second connection base (20) and the first connection base (10).

6. The connection apparatus (2) according to claim 5, wherein the plurality of first output ends (121) are located on a side of the plurality of first input ends (111) adjacent to the second connection base (20).

7. The connection apparatus (2) according to claim 5 or 6, wherein the plurality of first output ends (121) are spaced apart in the second direction, and the plurality of first output ends (121) respectively correspond to the plurality of first input ends (111); and
the plurality of second input ends (22) are spaced apart in the second direction, and the plurality of second input ends (22) are respectively connected to the plurality of first output ends (121).

8. The connection apparatus (2) according to any one of claims 5 to 7, wherein first connection holes (1211) are respectively formed in the plurality of first output ends (121); and
second connection holes (221) are respectively formed in the plurality of second input ends (22), and a plurality of first connection holes (1211) and a plurality of second connection holes (221) are respectively opposite to each other and connected by fasteners (16) to implement mechanical connection and electrical connection between the second connection base (20) and the first connection base (10).

9. The connection apparatus (2) according to any one of claims 5 to 8, wherein the plurality of second output ends (21) are located on a side of the plurality of second input ends (22) that is away from the first connection base (10).

10. The connection apparatus (2) according to any one of claims 5 to 9, wherein a plurality of mounting positions (133) are provided on at least one of the first connection portion (11) and the second connection portion (12).

11. The connection apparatus (2) according to claim 10, wherein the plurality of mounting positions (133) comprise:
a plurality of first mounting positions (13), wherein the plurality of first mounting positions (13) are provided on the first connection portion (11); and
a plurality of second mounting positions (14), wherein the plurality of second mounting positions (14) are provided on the second connection portion (12), and the plurality of second mounting positions (14) are respectively located on both sides of the plurality of first output ends (121).

12. The connection apparatus (2) according to claim 11, wherein the plurality of first mounting positions (13) comprise:
a plurality of first mounting sub-positions (131), wherein the plurality of first mounting sub-positions (131) are provided at an end of the first connection portion (11) that is away from the second connection portion (12), and the plurality of first mounting sub-positions (131) are arranged in the second direction; and
a plurality of second mounting sub-positions (132), wherein in the first direction, the plurality of second mounting sub-positions (132) are located between the plurality of first mounting sub-positions (131) and the plurality of second mounting positions (14).

13. The connection apparatus (2) according to any one of claims 5 to 12, wherein a plurality of guide slots (122) are formed in the second connection portion (12), and the plurality of first output ends (121) are respectively disposed within the plurality of guide slots (122); and
the plurality of second input ends (22) are respectively in guiding engagement with the plurality of guide slots (122) and respectively electrically connected to the plurality of first output ends (121).

14. The connection apparatus (2) according to any one of claims 2 to 13, wherein a plurality of positioning pins (134) are disposed on at least one of the first connection base (10) and the second connection base (20).

15. The connection apparatus (2) according to claim 14, wherein the plurality of positioning pins (134) comprise:
a plurality of first positioning pins (15), wherein the plurality of first positioning pins (15) are disposed at both ends of the first connection base (10) in the first direction, the plurality of first positioning pins (15) are located on a side of the first connection base (10) in a third direction, and the third direction, the first direction and the second direction are orthogonal; and
a plurality of second positioning pins (23), wherein the plurality of second positioning pins (23) are disposed at both ends of the second connection base (20) in the second direction, and the plurality of second positioning pins (23) are located on a side of the second connection base (20) that faces the first connection base (10).

16. The connection apparatus (2) according to claim 15, wherein one of the plurality of first positioning pins (15) is disposed at an end of the first connection portion (11) that is away from the second connection portion (12), and another of the plurality of first positioning pins (15) is disposed at an end of the second connection portion (12) in the second direction.

17. The connection apparatus (2) according to claim 15 or 16, wherein the plurality of first positioning pins (15) are integrally molded with the first connection base (10), and the plurality of second positioning pins (23) are integrally molded with the second connection base (20).

18. The connection apparatus (2) according to any one of claims 14 to 17, wherein the positioning pin (134) is a tapered positioning pin.

19. The connection apparatus (2) according to any one of claims 1 to 18, wherein a middle portion of the second connection base (20) is connected to an end of the first connection base (10) in the first direction.

20. A drive assembly (1), comprising:
a housing (3);
an electronic control apparatus (4), wherein the electronic control apparatus (4) is disposed within the housing (3);
a first motor (5);
a second motor (6), wherein the first motor (5) and the second motor (6) are disposed within the housing (3); and
a connection apparatus (2), wherein the connection apparatus (2) is the connection apparatus (2) according to any one of claims 1 to 19, the first motor (5) and the second motor (6) are electrically connected to the plurality of first input ends (111) of the first connection base (10) of the connection apparatus (2), and the electronic control apparatus (4) is electrically connected to the plurality of second output ends (21) of the second connection base (20) of the connection apparatus (2).

21. The drive assembly (1) according to claim 20, wherein the first motor (5) and the second motor (6) are located on both sides of the first connection base (10), and the first motor (5) and the second motor (6) are respectively electrically connected to the first input end (111) on a corresponding side.

22. The drive assembly (1) according to claim 20 or 21, wherein the housing (3) has a motor cavity (302) and an electronic control cavity (301), the first motor (5) and the second motor (6) are disposed within the motor cavity (302), the electronic control apparatus (4) is disposed within the electronic control cavity (301), the first connection base (10) is disposed within the motor cavity (302), and the second connection base (20) is disposed within the electronic control cavity (301).

23. The drive assembly (1) according to claim 22, further comprising:
a sealing member (17), wherein the sealing member is disposed between the second connection base (20) and the housing (3) to seal the motor cavity (302) and the electronic control cavity (301).

24. A vehicle (1000), comprising the connection apparatus (2) according to any one of claims 1 to 19 or the drive assembly (1) according to any one of claims 20 to 23.
